# EUROPÄISCHE PATENTSCHRIFT

(11) **EP 3 022 804 B1**
(45) Veröffentlichungstag und Bekanntmachung des Hinweises auf die Patenterteilung: **12.09.2018**
(21) Anmeldenummer: 14753021.6
(22) Anmeldetag: 15.07.2014
(51) Int. Cl.: H01R 9/05, H01R 13/6597, H01R 13/74

(54) **VORRICHTUNG ZUR ELEKTRISCHEN KONTAKTIERUNG EINER ABSCHIRMUNG EINES ELEKTRISCHEN KABELS AN EINEM GEHÄUSE SOWIE VORKONFEKTIONIERTES ELEKTRISCHES KABEL**
DEVICE FOR ESTABLISHING ELECTRICAL CONTACT BETWEEN A SHIELD OF AN ELECTRICAL CABLE AND A HOUSING, AND A PRE-ASSEMBLED CABLE
DISPOSITIF DE MISE EN CONTACT ÉLECTRIQUE D'UN BLINDAGE DE CÂBLE ÉLECTRIQUE AVEC UN BOÎTIER, ET CÂBLE ÉLECTRIQUE PRÉFABRIQUÉ

(30) Priorität: 17.07.2013 DE 202013006413 U
(43) Veröffentlichungstag der Anmeldung: 25.05.2016
(73) Patentinhaber: LEONI Bordnetz-Systeme GmbH, 97318 Kitzingen (DE)
(72) Erfinder: ALBERT, Volker, 97337 Dettelbach (DE); KETT, Alexander, 92706 Luhe-Wildenau (DE); PIECZKA, Michael, 58644 Iserlohn (DE); DEHN, Christian, 91227 Leinburg (DE)
(74) Vertreter: FDST Patentanwälte
(86) Internationale Anmeldenummer: PCT/EP2014/065174
(87) Internationale Veröffentlichungsnummer: WO 2015/007745

(56) Entgegenhaltungen:
- DE-A1-102010 014 982
- DE-A1-102010 052 627
- DE-U1-202004 014 020

## Beschreibung

Die Erfindung betrifft eine Vorrichtung zur elektrischen Kontaktierung einer Abschirmung eines elektrischen Kabels an einem Gehäuse mit den Merkmalen des Oberbegriffs des Anspruchs 1 sowie ein vorkonfektioniertes elektrisches Kabel mit den Merkmalen des Oberbegriffs des Anspruchs 14.

Die Erfindung betrifft dabei insbesondere eine derartige Vorrichtung und ein derartiges Kabel zum Einsatz in einem Elektro- oder Hybridfahrzeug als Hochvolt-Kabel zur Leistungsversorgung von elektrischen Hochvolt-Verbrauchern wie beispielsweise einem elektrischen Fahrmotor. Bei derartigen Hochvolt-Kabeln ist eine Abschirmung erforderlich, um die übrige Bordnetz-Elektronik frei von Störeinflüssen zu halten. Unter "Hochvolt" wird hierbei ein Spannungsbereich von typischerweise etwa 300V bis 800V verstanden.

Die Hochvolt-Kabel verbinden dabei eine Strom- und Spannungsquelle, insbesondere einen Akkumulator oder einen Generator mit einem Verbraucher, beispielsweise der elektrische Fahrmotor. Beim Anschluss des Kabels an der jeweiligen Komponente muss die Abschirmung des Kabels zuverlässig und sicher mit dem Gehäuse der jeweiligen Komponente elektrisch verbunden werden, um eine durchgehende Abschirmung zu erreichen. Dabei soll möglichst auch eine einfache, vorzugsweise reversible Montage des Kabels an der Komponente ermöglicht sein. Darüber hinaus muss in die Anschlussstelle zwischen Kabel und Komponente auch eine Zugentlastung integriert sein. Trotz einer gewünschten reversiblen Lösbarkeit des Kabels am Gehäuse ist eine sichere und langfristig zuverlässige Schirmanbindung gefordert. Heute bekannte Systeme zur Schirmanbindung sind im Allgemeinen vergleichsweise aufwendig. Beispielsweise erfolgen diese über eine Kabelverschraubung.

Aus der DE 10 2007 051 836 A1 ist ein Hochvoltkabelsatz für ein Kraftfahrzeug beschrieben, bei dem zur Schirmanbindung einer Abschirmung des Kabelsatzes an einer Gehäusedurchführung die Abschirmung zwischen einer Crimphülse und einer Unterziehhülse eingeklemmt ist. Die Unterziehhülse weist stirnseitig dabei einen Kopfbereich auf, mit dem sie elektrisch leitend an einer Befestigungsplatte anliegt, über die eine Schirmkontaktierung zu einem Gehäuse erfolgt.

Zur elektrischen Kontaktierung von Abschirmungen ist allgemein auch die Verwendung von beispielsweise hülsenförmigen Elementen mit Federzungen bekannt, bei denen die Federzungen elastisch gegen die Abschirmung gedrückt sind. Aus der EP 2 515 387 ist beispielsweise eine derartige Schirmkontaktierung zu entnehmen.

Aus der DE 10 2010 014 982 A1 ist darüber hinaus eine Steckverbindung mit einem Schirmkontaktelement zu entnehmen, wobei eine Kontaktierung der Abschirmung des Kabels mit einem Steckergehäuse des Steckerteils selbst erfolgt. Zur Kontaktierung der Abschirmung ist einerseits eine Crimphülsen-Anordnung aus einer Unterziehhülse und einer Crimphülse ausgebildet. Der elektrische Kontakt zwischen der Crimphülse und dem Gehäuse des Steckerteils wird über ein zusätzliches Hülsenteil erzielt, das einerseits die Crimphülse und andererseits die Gehäuseinnenwandung kontaktiert.

Weiterhin ist aus der DE 10 2010 052627 A1 eine Crimpverbindung einer mit einem Schirmgeflecht versehenen Mantelleitung zu entnehmen, bei der das Schirmgeflecht über einen Stützring und über eine Crimphülse mit einer Außenhülse elektrisch verbunden ist.

Ausgehend hiervon liegt der Erfindung die Aufgabe zugrunde, eine verbesserte Schirmkontaktierung zu ermöglichen.

Die Aufgabe wird gemäß der Erfindung gelöst durch eine Vorrichtung zur elektrischen Kontaktierung einer Abschirmung eines elektrischen Kabels an einem Gehäuse mit den Merkmalen des Anspruchs 1. Die Vorrichtung umfasst ein elektrisches Kabel, welches eine von einem Kabelmantel umgebene Abschirmung aufweist, wobei das Kabel im montierten Zustand durch einen Kabelstutzen des Gehäuses geführt ist. Die Vorrichtung umfasst weiterhin eine Unterziehhülse sowie eine Kontakthülse, wobei die Kontakthülse gegen die Unterziehhülse unter Zwischenlage der Abschirmung verpresst, insbesondere vercrimpt ist und mit dem Gehäuse elektrisch leitend verbunden ist. Die Kontakthülse weist weiterhin stirnendseitig mehrere, insbesondere kranzförmig umlaufend angeordnete Kontaktfedern auf, die nach Art von Federzungen radial nach außen gebogen sind. Mit diesen Federzungen liegt die Kontakthülse im montierten Zustand an der Innenwandung des Kabelstutzens ein, so dass eine elektrische Schirmkontaktierung zum Gehäuse erzielt ist.

Durch den Press- oder Crimpprozess erfolgt dabei eine Verformung der Kontakthülse, so dass zuverlässig und sicher die Abschirmung geklemmt und insbesondere formschlüssig gehalten ist. Neben der sicheren elektrischen Kontaktierung der Abschirmung ist sogleich auch eine gewisse Zugentlastung hierüber erreicht. Bevorzugt ist die Abschirmung unmittelbar zwischen der Unterziehhülse und der Kontakthülse angeordnet.

Von besonderem Vorteil und Bedeutung ist weiterhin, dass die einstückige Crimp- und Kontakthülse zugleich auch die Federzungen aufweist, so dass über diese einstückige Kontakthülse einerseits die zuverlässige Kontaktierung der Abschirmung durch die Crimpung und andererseits die Kontaktierung mit dem Gehäuse über die Federzungen erreicht ist. Die Kontakthülse weist daher eine Doppelfunktion auf. Im Hinblick auf die Crimpfunktion ist sie dabei einerseits geeignet plastisch verformbar, andererseits weist sie im Bereich der Federzungen eine ausreichende Elastizität auf, um die gewünschte elastische Anpressung an den Kabelstutzen zu gewährleisten. Dies erlaubt eine einfache Montage sowie auch eine einfache konstruktive Ausgestaltung der gesamten Vorrichtung.

Zweckdienlicherweise ist die Unterziehhülse dabei außenseitig auf dem Kabelmantel aufgebracht und ist aufgrund der Vercrimpung der Kontakthülse in den Kabelmantel eingepresst. Es erfolgt insofern bei nur einem Crimpvorgang eine Doppelcrimpung, nämlich zum Einen wird die Kontakthülse mit der Unterziehhülse verpresst und vercrimpt und gleichzeitig ist die ausgeübte Verformungskraft beim Crimpprozess derart bemessen, dass auch die Unterziehhülse in den Kabelmantel eingepresst wird. Insofern liegt eine doppelwirkende Verpressung vor. Durch das Einpressen der Unterziehhülse in den Kabelmantel ist diese am Kabel formschlüssig und damit auszugssicher gehalten. Dadurch ist eine zuverlässige Zugentlastung zusätzlich zu der sicheren Abschirmung ausgebildet.

Bevorzugt ist die Kontakthülse in einer Verschlusskappe angeordnet und liegt in dieser beispielsweise vollständig ein. Die Verschlusskappe ist daher über die Kontakthülse übergestülpt. Dadurch ist die Kontakthülse geschützt. Für ein vorkonfektioniertes Kabel, welches beispielsweise an einen Montageort transportiert wird, bildet daher die Verschlusskappe eine integrierte Transportsicherung zum Schutz der Kontakthülse. Die Verschlusskappe ist dabei an einer definierten Position am Kabelmantel fixiert, so dass sie nicht verrutscht.

Zweckdienlicherweise erfolgt die Befestigung des Kabels am Kabelstutzen über die Verschlusskappe, die vorzugsweise für eine reversible Befestigung am Kabelstutzen ausgebildet ist. Um eine möglichst einfache Montage sowie auch Demontage zu ermöglichen, ist dabei die Verschlusskappe mit einem Schnappelement versehen, welches mit einem korrespondierenden Schnappelement am Kabelstutzen zur Ausbildung einer bevorzugt reversibel lösbaren Schnappverbindung zusammenwirkt. Insbesondere ist daher die Verschlusskappe allgemein für eine werkzeuglose Befestigung an dem Kabelstutzen ausgebildet.

Im Hinblick auf eine möglichst zuverlässige Transportsicherung ist die Verschlusskappe dabei Teil einer mehrteiligen, insbesondere zweiteiligen, Kappenanordnung, welche neben der Verschlusskappe auch eine frontseitige Schutzkappe aufweist. Diese umschließt einen frontseitigen Teil der Kontakthülse und insbesondere den Teil der Kontaktzungen. Die Schutzkappe dient dabei lediglich als temporärer Transportschutz und wird daher für die Montage des Kabels am Gehäuse entfernt. Durch diese mehrteilige Kappenanordnung ist der Bereich der Kontakthülse vollständig und zuverlässig eingehaust. Gleichzeitig besteht dadurch die Möglichkeit, dass die Kontaktzungen in Längsrichtung aus der Verschlusskappe überstehen und in den Kabelstutzen möglichst tief eingeschoben werden können.

Kabelstutzen und Verschlusskappe greifen daher nach Art zweier Hülsen ineinander ein, wobei die Verschlusskappe den Kabelstutzen überstülpt. Die Verschlusskappe ist üblicherweise aus einem isolierenden Material ausgebildet, wohingegen das Gehäuse insbesondere auch für die elektrische Abschirmfunktion elektrisch leitend ist. Durch das Überstülpen der Verschlusskappe wird daher zugleich eine elektrische Isolierung des Kabelstutzens für eine Berührsicherheit erreicht.

Der Kabelstutzen liegt im montierten Zustand zwischen der Verschlusskappe und der Kontakthülse ein. Die Kontakthülse ist daher zur elektrischen Anbindung der Abschirmung des Kabels innenliegend des Kabelstutzens angeordnet und die Federzungen sind gegen die Innenwandung diesen Kabelstutzen gedrückt. Zwischen der Kontakthülse und der Verschlusskappe ist daher ein Ringraum ausgebildet, in den der hülsenförmige Kabelstutzen bei der Montage eingeschoben wird. Da dieser quasi zwischen Verschlusskappe und Kontakthülse eingeklemmt wird, wird die Kontakthülse mit einer definierten Anpresskraft gegen die Innenwandung des Kabelstutzens gepresst, um eine sichere elektrische Verbindung sicherzustellen.

Eine weitere Verbesserung der Kontaktsicherheit wird zweckdienlicherweise dadurch erreicht, dass die Kontakthülse beidendseitig Federzungen, insbesondere vollständig umlaufend aufweist. Die Kontakthülse weist also sowohl an ihrem vorderen als auch an ihrem hinteren Stirnende einen Kranz von radial nach außen ausgebogenen Federzungen auf.

Zweckdienlicherweise sind die Federzungen zueinander unterschiedlich ausgebildet und zwar derart, dass sie unterschiedliche mechanische Schwingungs-Eigenfrequenzen aufweisen. Diese Ausgestaltung geht von der Überlegung aus, dass beim Einsatz im Fahrzeug Vibrationen auftreten, die unter Umständen die Federzungen zum Schwingen anregen, so dass in ungünstigen Fällen der elektrisch leitende Kontakt zwischen einer jeweiligen Federzunge und dem Gehäuse zumindest kurzfristig unterbrochen wird. Durch unterschiedliche Ausgestaltung mit den verschiedenen Eigenfrequenzen ist nunmehr sichergestellt, dass selbst im ungünstigsten Fall zumindest einige der Federzungen weiterhin sicher elektrisch kontaktierend anliegen.

Im Hinblick auf eine möglichst einfache Herstellung der Kontakthülse ist diese aus einem Blechbiegestanzteil ausgebildet. In einem Verfahrensschritt wird hierbei aus einem ebenen Blech eine gewünschte Form mit den Federzungen ausgestanzt. Anschließend wird dieses flache Gebilde zur Hülse umgeformt. Beispielsweise werden an einer Stoßstelle gegenüberliegende Stirnseiten des Blechs miteinander verschweißt. Alternativ zur Ausgestaltung als Blechbiegestanzteil sind die Kontakthülse und vorzugsweise auch weitere Hülsen als Tiefziehteile ausgebildet.

Allgemein sind die Federzungen in Richtung zu dem Gehäuse, an der die elektrische Kontaktierung erfolgen soll, scharfkantig ausgebildet. Durch diese scharfkantige Ausbildung wird eine evtl. sich an der Oberfläche des Gehäuses ausbildende Oxidschicht für eine zuverlässige elektrische Anbindung durchbrochen. Die scharfkantige Ausbildung wird dabei zweckdienlicherweise durch einen Stanzgrat verwirklicht, welcher beim Stanzvorgang bewusst nicht entgratet wird.

Neben der elektrischen Anbindung der Abschirmung an das Gehäuse ist grundsätzlich auch eine abgedichtete Durchführung des Kabels durch den Kabeleingang erforderlich. Um diese zu gewährleisten liegt in der Verschlusskappe ein Dichtungselement ein, durch welches das Kabel geführt ist.

Innerhalb der Verschlusskappe ist dabei ein insbesondere bodenseitiger, geschlossener Dichtraum gebildet. Dieser ist gemäß einer ersten Variante von einem in Richtung zur Kontakthülse orientierten Halter abgeschlossen. Das Dichtelement liegt daher zuverlässig in einem definierten Raum zwischen Halter und Verschlusskappe ein.

Der Halter schließt sich dabei in Kabellängsrichtung vorzugsweise an die stirnendseitig am Kabel befestigte Kontakthülse an, so dass der Halter aufgrund des mechanischen Anschlags an der im Kabelmantel vercrimpten Kontakthülse einen in Längsrichtung wirksamen Anschlag für das Dichtelement bildet.

Der Halter ist dabei zweckdienlicherweise hülsenförmig über den Kabelmantel gestülpt und umfasst einen Hülsenschaft, mit dem er am Kabelmantel anliegt. Im Hinblick auf eine platzsparende Ausgestaltung ist dabei die Kontakthülse mit ihrem einen Endbereich über diesen Hülsenschaft gestülpt. Der Hülsenschaft erstreckt sich daher insbesondere in das durch den Kranz der Federzungen gebildetes Stirnende der Kontakthülse hinein.

Vorzugsweise ist weiterhin ein Abstandshalter angeordnet, welcher einen Ringsteg aufweist, welcher das Kabel im Kabeleingang zentriert hält. Der Abstandshalter ist dabei insbesondere durch den beschriebenen Halter gebildet. Der Ringsteg dient daher neben der Zentrierung des Kabels innerhalb des Kabelstutzens zugleich auch als Anschlag für das Dichtelement.

Der Halter bzw. der Abstandshalter ist gemäß einer ersten Ausführungsvariante dabei ein eigenständiges Bauteil. In einer alternativen Ausgestaltung ist der Abstandshalter als ein Teilbereich der Unterziehhülse selbst ausgebildet. Diese weist in dem Fall also den Ringsteg oder Kragen auf. Dadurch wird die Teilevielzahl weiter reduziert.

Um eine definierte Position der Kontakthülse innerhalb des Kabelstutzens für eine sichere elektrische Anbindung zu gewährleisten, weist dieser einen Anschlag auf, an den sich die Kontakthülse in Längsrichtung zumindest mittelbar und in einer Ausführungsvariante unmittelbar abstützt. Neben der in Radialrichtung wirkenden Klemmung der Kontakthülse aufgrund der Federzungen ist bevorzugt auch eine in Axialrichtung wirkende Klemmung erzielt, so dass die Kontakthülse insgesamt gespannt einliegt.

Gemäß einer bevorzugten Ausführungsvariante ist die Kontakthülse von einer Zwischenhülse umgeben. Diese ist im montierten Zustand zwischen der Kontakthülse und dem Kabelstutzen positioniert. Bei dieser Zwischenhülse handelt es sich dabei vorzugsweise um eine Kunststoffhülse. Diese dient insbesondere zur weitergehenden Positionierung und Führung der Kontakthülse beispielsweise beim Transport des Kabels zu einem Montageort oder dann auch in der montierten Stellung innerhalb des Kabelstutzens.

Für eine einfache Montage ist die Zwischenhülse dabei mehrschalig ausgebildet, insbesondere durch zwei Halbschalen, so dass die Zwischenhülse um die Kontakthülse gelegt werden kann.

In zweckdienlicher Ausgestaltung ist dabei vorgesehen, dass die Zwischenhülse zur formschlüssigen axialen Fixierung der Kontakthülse innerhalb des Kabelstutzens ausgebildet ist. Über diese Zwischenhülse wird daher die Kontakthülse innerhalb des Kabelstutzens ortsfest positioniert. Hierzu ist die Kontakthülse zwischen einem Anschlag des Kabelstutzens einerseits und einem Crimpteil, also wahlweise die Kontakthülse oder die Unterziehhülse, positioniert. Hierzu weist das Crimpteil einen in Radialrichtung abstehenden Ringsteg oder Kragen auf. Über die bereits erwähnte Doppelcrimpung ist die Kontakthülse ortsfest am Kabelaußenmantel fixiert. Durch den Kragen wird zusätzlich zum Anschlag am Kabelstutzen ein weiterer Anschlag gebildet, so dass über diese beiden definierten Anschläge und der Zwischenhülse ein in beide Richtungen wirkender Formschluss in Längsrichtung des Kabels ausgebildet ist.

In bevorzugter Ausgestaltung ist um die Kontakthülse eine Hilfshülse angeordnet, die quasi als Crimphilfe dient. Bei dieser Ausführungsvariante wird die insbesondere aus einem Blechbiegestanzteil gefertigte Kontakthülse mit Hilfe der Hilfshülse in der vorgegebenen Hülsengeometrie gehalten. Es ist bei dieser Variante beispielsweise kein Verbinden (Verschweißen) von gegenüberliegenden Stirnseiten erforderlich und bevorzugt auch nicht vorgesehen. Die Hilfshülse besteht beispielsweise aus Metall. Alternativ hierzu besteht sie aus Kunststoff oder auch aus einem anderen elastischen Material. Bei der Montage wird sie bereits vor dem Crimpprozess aufgebracht, so dass sie als Crimphilfe dient.

Zweckdienlicherweise ist im Anschlussstutzen ein Einsatz angeordnet, welcher aus einem im Vergleich zum Anschlussstutzen verschiedenen Material besteht. Bei diesem Material handelt es sich um ein Material mit besonders guter elektrischer Leitfähigkeit. An diesem Einsatz liegen die Federzungen im montierten Zustand an. Dadurch werden eine möglichst gute elektrische Anbindung und möglichst geringe elektrische Kontaktwiderstände erzielt. Bei dem Material für den Einsatz wird insbesondere eine Kupferlegierung beispielsweise eine Kupfer-ZinkLegierung oder auch Zinn oder eine Zinnlegierung verwendet. Das Material des Anschlussstutzens ist häufig - wie auch das des gesamten Gehäuses - Aluminium.

Die Aufgabe wird gemäß der Erfindung weiterhin gelöst durch ein vorkonfektioniertes Kabel mit den Merkmalen des Anspruchs 14 für eine derartige Vorrichtung. Die im Hinblick auf die Vorrichtung angeführten Vorteile und bevorzugten Ausgestaltungen sind sinngemäß auch auf das vorkonfektionierte elektrische Kabel zu übertragen.

Das elektrische Kabel ist dabei im Montageendzustand innerhalb eines Elektro- oder Hybridfahrzeuges angeordnet und ist an einer elektrischen Komponente des Fahrzeugs angeschlossen.

Ein Ausführungsbeispiel der Erfindung wird nachfolgend anhand der Figuren näher erläutert. Diese zeigen teilweise in vereinfachten Darstellungen:
- FIG 1A: eine vereinfachte perspektivische Übersichtsdarstellung der Befestigung eines Hochvolt-Kabels an einem Gehäuse mit Blickrichtung auf die Außenseite des Gehäuses,
- FIG 1B: die Befestigung des Hochvolt-Kabels gemäß FIG 1A mit Blickrichtung auf die Innenseite des Gebläses,
- FIG 2: eine Querschnittsdarstellung im Anschlussbereich der in den FIG 1A und 1B dargestellten Verbindung zwischen Kabel und Gehäuse,
- FIG 3A: eine perspektivische ausschnittsweise Darstellung eines Hochvolt-Kabels zur Erläuterung des Montagevorgangs der einzelnen Komponenten zur Ausbildung eines vorkonfektionierten Kabels,
- FIG 3B: eine weitere ausschnittsweise perspektivische Darstellung des Kabels zur weiteren Erläuterung der Montage,
- FIG 4: eine ausschnittsweise Schnittdarstellung zur Erläuterung des Pressvorgangs zur Ausbildung einer Doppelcrimpung zwischen Kontakthülse und Unterziehhülse einerseits sowie zwischen Unterziehhülse und Kabelmantel andererseits,
- FIG 5: eine perspektivische Explosionsdarstellung einer weiteren Ausführungsvariante eines Hochvoltkabels zusammen mit einem ausschnittsweise dargestellten Gehäuse mit Kabelstutzen,
- FIG 6: eine ausschnittsweise Querschnittdarstellung des Kabels gemäß FIG 5 im montierten Zustand im Kabelstutzen,
- FIG 7: eine ausschnittsweise vergrößerte Querschnittsdarstellung des Kabels gemäß FIG 5 bei einer alternativen Ausgestaltung des Kabelstutzens mit einem Einlegeteil zur verbesserten Kontaktierung,
- FIG 8: eine ausschnittsweise Explosionsdarstellung des Kabels in einem Zwischenmontagezustand mit einer zweiteiligen Kappenanordnung für einen Transportschutz des Kabels sowie
- FIG 9: eine ausschnittsweise perspektivische Darstellung eines Kabelendes des Kabels gemäß FIG 5, wie es für den Transport vorbereitet ist.

In den Figuren sind gleichwirkende Teile jeweils mit den gleichen Bezugszeichen versehen.

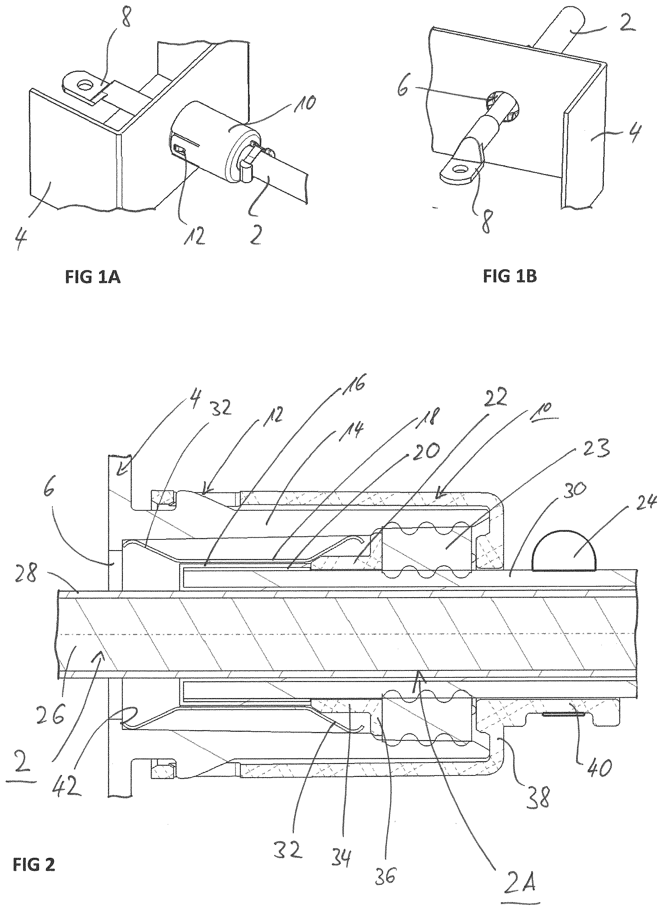

Gemäß den FIG 1A und 1B ist ein elektrisches Hochvolt-Kabel 2 an einem bevorzugt metallischen Gehäuse 4 angeschlossen und durch einen Kabeleingang 6 des Gehäuses 4 in einen Innenraum hineingeführt. Das Kabel 2 endet in dem Innenraum üblicherweise an einem Kontaktelement 8, beispielsweise ein Kontaktschuh, wie er in den FIG 1A, B dargestellt ist. Über dieses Kontaktelement 8 wird das Kabel 2 an einem Kontaktpol beispielsweise über eine Schraubverbindung angeschlossen. Das metallische Gehäuse ist beispielsweise ein Metallguss-Gehäuse, insbesondere ein Aluminiumdruck-Gehäuse.

Wie insbesondere aus der FIG 2 auch in Verbindung mit FIG 1A zu entnehmen ist, ist für die mechanische Befestigung des Kabels 2 am Gehäuse 4 eine etwa topfförmige Verschlusskappe 10 am Kabel 2 angeordnet, welche über eine Schnappverbindung 12 mit dem Gehäuse 4 reversibel lösbar befestigt ist. Hierzu umfasst der Kabeleingang 6 einen Kabelstutzen 14, der sich in Kabellängsrichtung nach außen hülsenförmig erstreckt. Er weist an seiner Außenseite mehrere, im Ausführungsbeispiel zwei gegenüberliegend angeordnete Rastnasen auf, die zur Ausbildung der Schnappverbindung 12 in eine entsprechende Rastausnehmung der Verschlusskappe 10 eingreifen. Wie insbesondere aus FIG 1A zu entnehmen ist, ist die Verschlusskappe 10 beidseitig der jeweiligen Schnappaufnahme geschlitzt ausgebildet, so dass ein elastisches Aufbiegen der Verschlusskappe 10 im Bereich der Schnappaufnahme ermöglicht ist. Die Befestigung des Kabels 2 am Kabelstutzens 14 erfolgt daher durch einfaches Aufstecken der Verschlusskappe 10 bis die Schnappverbindung 12 ausgebildet ist.

Das Gehäuse 4 ist üblicherweise elektrisch leitend ausgebildet. An dieses Gehäuse 4 ist eine Abschirmung 16 des Kabels 2 elektrisch leitend und um 360° umlaufend anzuschließen, um eine durchgehende zuverlässige Abschirmung zu gewährleisten.

Ein geeignet vorkonfektioniertes Kabel zur elektrischen Kontaktierung dieser Abschirmung 16 umfasst dabei neben der bereits erwähnten Verschlusskappe 10 weiterhin eine Kontakthülse 18, eine Unterziehhülse 20, einen Abstandshalter 22, ein Dichtelement 23 sowie zur Fixierung der Verschlusskappe 10 am Kabel 2 ein Fixierelement 24, welches im Ausführungsbeispiel als Kabelbinder ausgebildet ist.

Die Kontakthülse besteht hierbei vorzugsweise aus einem Kupfer-Werkstoff mit Federeigenschaften und insbesondere einer verzinnten Oberfläche. Auch die Unterziehhülse besteht typischerweise aus einem derartigen Kupfer-Werkstoff. Der Abstandshalter 22 ist beispielsweise als Kunststoff-Teil ausgebildet. Das Dichtelement 23 ist insbesondere als Silikon-Dichtelement ausgebildet. Die Verschlusskappe 10 wiederum ist ein Kunststoffteil und beispielsweise aus dem gleichen Material wie der Abstandshalter 22, beispielsweise aus einem Polyamid.

Das Kabel 2 weist allgemein eine Leiterader 26 auf, die von einer Aderisolierung 28 umgeben ist, welche wiederum von der beispielsweise als metallisches Schirmgeflecht ausgebildeten Abschirmung 16 umgeben ist. Diese wiederum ist von einem Kabelmantel 30 umgeben. Bei der Leiterader 26 handelt es sich beispielsweise um eine Litze bestehend aus einer Vielzahl von Einzeldrähten, um eine hohe Biegeflexibilität zu ermöglichen. Das Kabel 2 ist insgesamt zur Übertragung von hohen Leistungen von mehreren KW elektrischer Leistung sowie für hohe Spannungen ausgelegt.

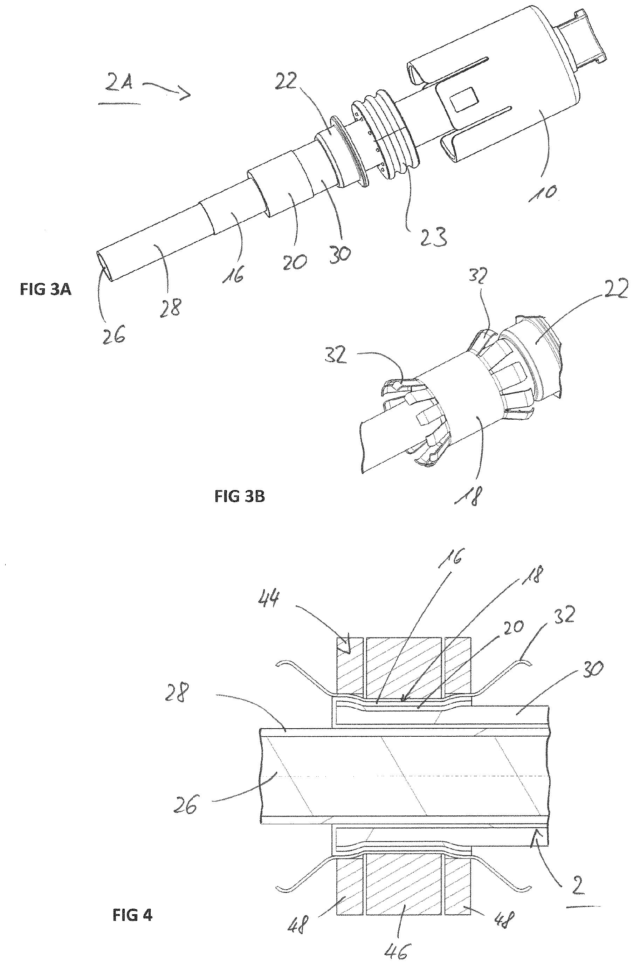

Wie insbesondere sich anhand der Querschnittsdarstellungen der FIG 2 entnehmen lässt, ist die Abschirmung 16 um ein stirnseitiges Ende des Kabelmantels 30 etwa um 180° umgeschlagen, wobei auf den Kabelmantel 30 die Unterziehhülse 20 angebracht ist, so dass also die Unterziehhülse 20 zwischen Kabelmantel 30 und dem umgeschlagenen Teilbereich der Abschirmung 16 einliegt. In diesem Bereich der Unterziehhülse 20 ist die Kontakthülse 18 mit einem Mittenbereich angeordnet, von dem aus sich beidseitig radial nach außen gewölbte Stirnenden der Kontakthülse anschließen. Diese Stirnenden bestehen jeweils aus einem umlaufenden Kranz, gebildet durch eine Vielzahl von einzelnen Federzungen 32, die jeweils eine Kontaktfeder definieren (vgl. hierzu insbesondere auch die FIG 3B).

Alternativ zu der dargestellten Ausführungsvariante der Kontakthülse 18 mit den beidendseitig aufgeweiteten Enden, die den Kranz der Federzungen 32 bilden ist lediglich ein Ende der Kontakthülse 18 aufgeweitet und am gegenüberliegenden, zum Abstandshalter 22 orientierten Ende ist das aufgeweitete Ende durch ein entsprechendes aufgeweitetes Ende der Unterziehülse 20 ersetzt. In dieser alternativen Ausgestaltung sind daher die Kontakthülse 18 und die Unterziehülse 20 jeweils an einem Ende zur Ausbildung eines Kranzes an Federzungen 32 aufgeweitet. In dem radial nach außen gezogenem Ende der Unterziehülse 20 liegt daher der Abstandshalter 22 ein - so wie gemäß Fig. 2 der Abstandshalter 22 im aufgeweiteten Ende der Kontakthülse 18 einliegt. Beide Hülsen 18,20 sind dabei beispielsweise als Tiefziehteile ausgebildet.

In Längsrichtung des Kabels schließt sich an den Mittenbereich der Kontakthülse 18 der hülsenförmige Abstandshalter 22 an. Dieser umfasst einen Hülsenschaft 34, der endseitig in einen Ringsteg 36 übergeht. An den Ringsteg 36 schließt sich unmittelbar das Dichtelement 23 an.

Das Dichtelement 23 weist sowohl an seiner Innenoberfläche als auch an seiner umfangsseitigen Außenoberfläche ein Profil, insbesondere Wellenprofil auf, so dass einzelne Dichtstege ausgebildet sind, um eine zuverlässige und sichere Abdichtung einerseits zum Kabel 2 und andererseits zum Kabelstutzen 14 auszubilden.

Der Abstandshalter 22 schließt dabei unmittelbar an die Kontakthülse 18 sowie die Unterziehhülse 20 an, stützt sich dabei insbesondere an zumindest einem dieser Bauteile in Längsrichtung ab. Gleichzeitig sind die Federzungen 32 über den Hülsenschaft 34 übergestülpt, so dass insgesamt eine möglichst kompakte Ausgestaltung erreicht ist.

Über den Abstandshalter 22 wird das Kabel 2 zentriert innerhalb des Kabelstutzens gehalten. Der Ringsteg 36 ist daher in seiner radialen Ausdehnung derart bemessen, dass er an den Innendurchmesser des Kabelstutzens angepasst ist.

Vorzugsweise umfasst der Kabelstutzen 14 dabei - wie in FIG 2 zu erkennen ist - an seiner Mantelinnenseite auf der Höhe des Ringstegs 36 (in der Montageendposition) einen insbesondere durch eine Materialverdickung hervorgerufenen Rücksprung, welcher beispielsweise als Schräge oder auch wie dargestellt als gerundete Stufe ausgebildet ist. Diese gerundete Stufe definiert dabei insoweit eine Einführhilfe für den Ringsteg 36. Zweckdienlicherweise ist dabei der Ringsteg 36 derart bemessen, dass er sowohl in axialer als auch in radialer Richtung an der Wandung des Kabelstutzens 14 anschlägt.

Im stirnseitigen vorderen Bereich vor dem Rücksprung weist daher der Kabelstutzen 14 eine Ringmantelfläche mit etwas vergrößertem Innendurchmesser auf. Diese Ringmantelfläche bildet dabei eine Dichtfläche aus, welche insbesondere eine hohe Oberflächengüte aufweist und beispielsweise separat nachbehandelt wurde. An seinem vorderen Stirnende weist schließlich der Kabelstutzen noch eine Einführfase auf.

Die Verschlusskappe 10 selbst ist insgesamt in etwa topfförmig ausgebildet und nimmt die zuvor beschriebenen Elemente in dem von ihr gebildeten Kappeninnenraum auf. Sie umgibt daher insbesondere auch die Kontakthülse 18 und bildet somit für diese einen mechanischen (Transport-) Schutz, um das vorkonfektioniertes Kabel an den Montageort ohne Beschädigungsgefahr transportieren zu können.

Die Verschlusskappe 10 weist dabei einen ringförmigen Boden 38 auf, durch den das Kabel 2 durchgeführt ist. An den Boden 38 schließt sich über einen Teilumfang ein Haltesteg 40 an, über den die Fixierung mit Hilfe des Fixierelements (z. B. Kabelbinder) am Kabelmantel 30 erfolgt. Über diese Fixierung ist die ansonsten verschieblich am Kabelmantel 30 gehaltene Verschlusskappe 10 in einer gewünschten Position am Kabel 2 gehalten.

Wie insbesondere aus der FIG 2 zu erkennen ist, greift der Kabelstutzen 14 in einen Ringraum zwischen der Verschlusskappe 10 und der Kontakthülse 18 ein und reicht bis zum Boden 38. Die Federzungen 32 werden mit ihrer Federkraft zuverlässig gegen die Innenwand des Kabelstutzens 14 gedrückt. Unmittelbar im Bereich des Kabeleingangs 6 ist weiterhin ein Anschlag 42 ausgebildet, an dem der vordere Kranz der Federzungen 32 anliegt.

Das Kabel 2 wird als vorkonfektioniertes Kabel 2A zur Montage an dem Gehäuse 4 bereitgestellt und beispielsweise von einem Zulieferer an die Produktionsstraße des Automobilherstellers geliefert. Das vorkonfektionierte Kabel 2A zeigt dabei den gleichen Aufbau wie in FIG 2 dargestellt, lediglich ohne das Gehäuse 4. Das vorkonfektionierte Kabel 2A braucht daher zur Befestigung am Gehäuse 4 lediglich noch mit diesem über die Verschlusskappe 10 verrastet werden.

Die Montage der einzelnen Komponenten der Vorrichtung des vorkonfektionierten Kabels 2A wird nachfolgend anhand der FIG 3A, B sowie 4 näher erläutert. In einem ersten Schritt wird das Kabel 2 an einer Stirnendseite abgemantelt, also der Kabelmantel 30 über eine definierte Länge entfernt. Anschließend wird die Abschirmung 16 auf eine gewünschte Länge geschnitten. Danach werden auf das derart präparierte Kabel 2 zunächst die Verschlusskappe 10, anschließend das Dichtelement 23, dann der Abstandshalter 22 und schließlich die Unterziehhülse 20 aufgeschoben. Die Unterziehhülse schließt dabei stirnseitig mit dem verbleibenden Kabelmantel 30 ab. Diese Zwischenmontageposition des vorkonfektionierten Kabels 2A ist in FIG 3A dargestellt.

Im nächsten Schritt wird die Abschirmung 16 um 180° zurückgeklappt und über die Unterziehhülse 20 gelegt. Danach erfolgt das Aufschieben der Kontakthülse 8 über die Abschirmung 16. Diese Zwischenmontageposition ist in FIG 3B dargestellt.

Schließlich erfolgt das gleichzeitige Verpressen sowohl der Kontakthülse 18 als auch der Unterziehhülse 20 mit Hilfe eines Press- oder Crimpvorgangs. Dieser ist schematisch in FIG 4 dargestellt. Ein entsprechendes Presswerkzeug 44 übt eine radiale Presskraft in einem Mittenbereich aus, so dass sowohl die Kontakthülse 18 als auch die Unterziehhülse 20 verformt werden und die Unterziehhülse 20 in den Kabelmantel 30 eingepresst wird. Dadurch ist eine hohe Auszugsfestigkeit zwischen Unterziehhülse 20 und Kabelmantel 30 einerseits erzielt. Gleichzeitig ist auch durch die Pressverbindung und den Kraft- und Formschluss zwischen Kontakthülse 18 und Unterziehhülse 20 eine zugfeste Verbindung ausgebildet. Bei einer Zugbeanspruchung wird daher die Zugkraft von dem Kabelmantel 30 auf die Unterziehhülse 20 übertragen, von dieser über den Abstandshalter 22 und das Dichtelement 23 schließlich auf die Verschlusskappe 10, die dann die Zugkraft über die mechanische Schnappverbindung 12 in das Gehäuse 4 einleitet. Insgesamt ist daher eine zuverlässige mechanische Zugentlastung gebildet.

Zur Ausbildung der Verpressung weist das Presswerkzeug 44 einen zentralen Pressstempel 46 auf, welcher von einem Niederhalter 48 eingeschlossen ist. Über den Niederhalter 48 wird eine definierte Umformung gewährleistet.

Nach dem Pressvorgang wird der Abstandshalter 22 wieder nach vorne bis auf Anschlag zur Kontakthülse 18 herangeführt und anschließend werden Dichtelement 23 und Verschlusskappe 10 jeweils bis etwa auf Anschlag nachgeschoben. In dieser Position wird dann das Fixierelement 24 zur Fixierung der Verschlusskappe 10 am Kabelmantel 30 befestigt. Anschließend wird an die freigelegte Leiterader 26 noch das Kontaktelement 8 beispielsweise durch Crimpen befestigt.

Das derart vormontierte Kabel 2 braucht zur Endmontage dann lediglich durch den Kabelstutzen 14 hindurch geführt werden bis die Verschlusskappe 10 am Gehäuse 4 rastet. Es handelt es sich hier daher um eine einfache Steckverbindung.

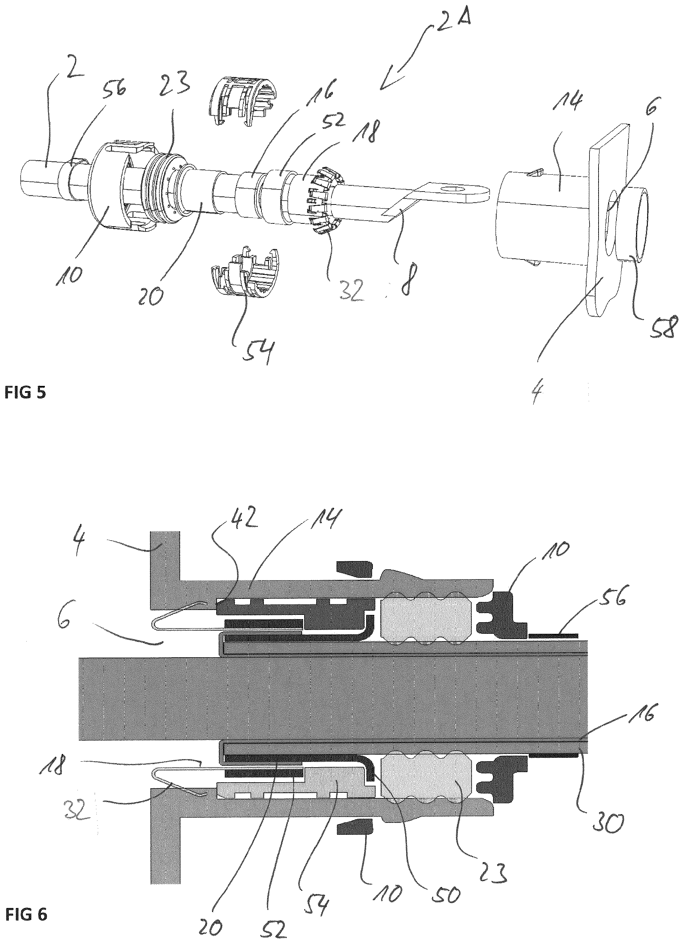

Anhand der FIG 5 bis 9 wird nachfolgend eine zweite Ausführungsvariante der Vorrichtung sowie des vorkonfektionierten Kabels 2A erläutert. Diese zweite Ausführungsvariante weist ebenso wie die erste Ausführungsvariante, eine Unterziehhülse 20 sowie eine als Crimphülse ausgebildete Kontakthülse 18 auf. Zwischen diesen beiden Hülsen 18,20 ist die Abschirmung 16 eingeklemmt. Auch hier erfolgt eine Doppelcrimpung, so dass auch eine Verpressung mit dem Kabelaußenmantel 30 erfolgt.

Ebenso wie bei der ersten Ausführungsvariante ist auch hier das Dichtelement 23 zwischen dem Kabelmantel 30 und dem Kabelstutzen 14 eingelegt. Zudem erfolgt die Befestigung des Kabels 2 an Gehäuse 4 ebenfalls wiederum über eine Schnappverbindung mit Hilfe der Verschlusskappe 10.

Im Unterschied zu der ersten Ausführungsvariante weist die Kontakthülse 18 jedoch lediglich an der Frontseite einen Kranz aus Federzungen 32 auf. An diesen nach außen aufgebogenen Kranz schließt sich ein Zylinderabschnitt der Kontakthülse 18 an.

Die Unterziehhülse 20, welche im ersten Ausführungsbeispiel als reine Zylinderhülse ausgebildet ist, weist bei dieser Ausführungsvariante an ihrem hinteren, den Federzungen 32 abgewandten Ende einen Kragen 50 auf, welcher durch eine Umbiegung ausgebildet ist. Der Kragen 50 ist dabei insbesondere ringförmig ausgebildet.

Die Kontakthülse 18 ist weiterhin in ihrem rückwärtigen, zylinderförmigen Bereich von einer Hilfshülse 52 umgeben, welche insbesondere als Crimphilfe dient. Diese liegt daher unmittelbar an der Kontakthülse 18 an und hält diese in der gewünschten Form. Bei der Kontakthülse 18 handelt es sich dabei insbesondere wiederum um ein Stanzbiegeteil aus Blech, welches zur Hülse ringförmig gebogen ist. Die Stoßstelle zwischen den beiden Enden des Bleches sind bei dieser Variante nicht stoffschlüssig miteinander verbunden. Die Hilfshülse 52 hält die Kontakthülse 18 in Form. Die Hilfshülse 52 wird bereits vor dem Crimpvorgang über die Kontakthülse 18 geschoben.

Weiterhin weist das Kabel 2 in zweckdienlicher Ausgestaltung eine insbesondere aus zwei Halbschalen gebildete Zwischenhülse 54 auf, welche die Crimpelemente, also die Kontakthülse 18 und die Unterziehhülse 20 sowie - sofern diese vorliegt - auch die Hilfshülse 52 radial umgibt. Dabei weist die Zwischenhülse 54 in Axialrichtung einen vorderen Abschnitt auf, welcher sich die Kontakthülse 18 und die Hilfshülse 52 umgibt und einen rückwärtigen Abschnitt, welcher unmittelbar an die Unterziehhülse 20 in radialer Richtung anschließt. Die beiden Abschnitte schließen dabei insbesondere unter Ausbildung einer Stufe aneinander an. Die Zwischenhülse 54 weist in beiden Axialabschnitten den gleichen Außenumfang auf. Durch den zum hinteren Abschnitt gebildeten Absatz liegt die Zwischenhülse 54 zwischen dem Kragen 50 und der Kontakthülse 18 und/oder der Hilfshülse 52 insbesondere formschlüssig ein. Dadurch ist eine axiale Fixierung erreicht. Zugleich liegt die Zwischenhülse 54 mit einer vorderen Stirnseite an dem Anschlag 42 des Kabelstutzens 14 an. Insgesamt ist dadurch eine axiale Auszugssicherung erreicht. Diese wird zudem auch unterstützt über die Verbindung des Kabelstutzens 14 mit der Verschlusskappe 10. Auch bei der zweiten Ausführungsvariante ist hierzu vorzugsweise eine Schnappverbindung 12 ausgebildet. Die Verschlusskappe 10 ist wiederum beispielsweise mittels eines Kabelbinders 56 oder eines anderen Fixierelements am Kabel 2 fixiert.

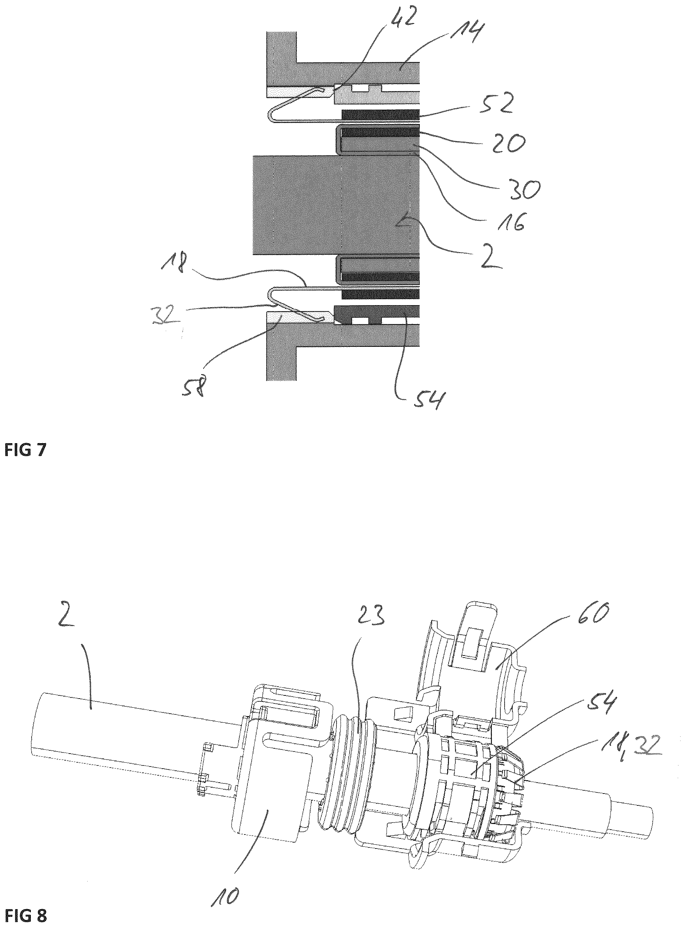

Im Unterschied zu der ersten Ausführungsvariante liegt die Zwischenhülse 54 formschlüssig am Anschlag 42 an und nicht etwa die Federzungen 32. Diese stehen in Längsrichtung über den Anschlag 42 über und werden in radialer Richtung gegen diesen gepresst. Dabei werden die Federzungen - anders als in den Schnittdarstellungen der Figuren 6 und 7 dargestellt - nach innen elastisch verformt, so dass sie an der Innenoberfläche des Kabelstutzens 14 anliegt.

Bei der Ausführungsvariante gemäß der FIG 6 ist der Anschlag 52 einstückiger Bestandteil des Kabelstutzens 14, welcher also an seiner Innenwandung eine Stufe ausbildet.

In alternativer Ausgestaltung hierzu ist der Anschlag zweckdienlicherweise durch einen Einsatz 58 gebildet, wie dies in FIG 7 dargestellt ist. Bei diesem Einsatz handelt es sich insbesondere um einen Ring, beispielsweise um einen Einpressring. Alternativ ist dieser beispielsweise durch Schweißen oder Löten mit der Innenwandung des Kabelstutzensl 4 verbunden. Dieser Einsatz 58 besteht aus einem zum Kabelstutzen 14 verschiedenen Material mit guter elektrischer Leitfähigkeit, insbesondere aus einer Kupferlegierung, beispielsweise eine Kupfer-ZinnLegierung oder auch aus Zink oder einer Zinklegierung.

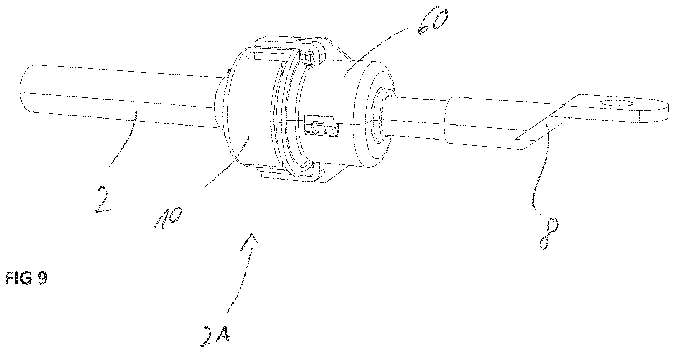

Wie insbesondere aus den FIG 8 und 9 hervorgeht, ist zu Transportzwecken zusätzlich zu der Verschlusskappe 10 noch eine Schutzkappe 60 vorgesehen, welche die einzelnen Crimpelemente zumindest teilweise und vorzugsweise in Längsrichtung vollständig einhaust. Die Schutzkappe 60 ist dabei vorzugsweise aus zwei Halbschalen gebildet, die beispielsweise über Filmscharniere oder dergleichen miteinander verbunden sind. Die Schutzkappe 60 kann dadurch in einfacher Weise um die Crimpteile angebracht und wieder abgenommen werden. Insbesondere - wie aus der FIG 8 zu entnehmen ist - umgibt die Schutzkappe 60 die Crimpelemente, also die Kontakthülse 18 sowie die Unterziehhülse 20 in Längsrichtung vollständig. Dadurch schließt sie auch die Zwischenhülse 54 zwischen sich ein.

Die Schutzkappe 60 ist mit der Verschlusskappe 10 bei der Montage verbunden, so dass die beiden Kappen 10,60 aneinander fixiert sind. Hierzu ist insbesondere eine Verrastung vorgesehen. Zweckdienlicherweise greift dabei die Schutzkappe 60 mit einem Rastelement in das gleiche Rastelement der Schutzkappe 10 ein, welches auch für die spätere Verrastung der Verschlusskappe 10 mit dem Kontaktstutzen 14 verwendet wird.

Bei der Montage und Vorkonfektionierung des vorkonfektionierten Kabels 2A wird zunächst das Kabel 2 auf die gewünschte Länge abgeschnitten und am stirnseitigen Ende die zentrale Leiter oder sowie die Abschirmung 16 in an sich bekannter Weise freigelegt. Anschließend wird zunächst die Verschlusskappe 10 und das Dichtelement 23 auf den Kabelmantel 30 aufgeschoben. Danach wird die Unterziehhülse 20 aufgeschoben und die Abschirmung wird um 180° umgebogen, so dass sie auf dem Außenmantel der Unterziehhülse 20 zum Aufliegen kommt. Danach wird die vorbereitete Baugruppe, bestehend aus Kontakthülse18 und Hilfshülse 52 über die Abschirmung 16 geschoben. Darauf erfolgt der wie bereits zu der ersten Ausführungsvariante beschriebene Crimpprozess. Anschließend an den Crimpprozess wird die Zwischenhülse 54 angeordnet, bevor dann die Schutzkappe 60 angebracht und mit der Verschlusskappe 10 verbunden wird. Die Verschlusskappe 10 wird dann mittels des Kabelbinders 56 am Kabel 2 fixiert. Zuletzt wird schließlich noch das Kontaktelement 8 auf die Leiterader 26 aufgecrimpt.

### Bezugszeichenliste

- 2: Kabel
- 2A: vorkonfektioniertes Kabel
- 4: Gehäuse
- 6: Kabeleingang
- 8: Kontaktelement
- 10: Verschlusskappe
- 12: Schnappverbindung
- 14: Kabelstutzen
- 16: Abschirmung
- 18: Kontakthülse
- 20: Unterziehhülse
- 22: Abstandshalter
- 23: Dichtelement
- 24: Fixierelement
- 26: Leiterader
- 28: Aderisolierung
- 30: Kabelmantel
- 32: Federzunge
- 34: Hülsenschaft
- 36: Ringsteg
- 38: Boden
- 40: Haltesteg
- 42: Anschlag
- 44: Presswerkzeug
- 46: Pressstempel
- 48: Niederhalter
- 50: Kragen
- 52: Hilfshülse
- 54: Zwischenhülse
- 56: Kabelbinder
- 58: Einsatz
- 60: Schutzkappe

## Patentansprüche

1. Vorrichtung zur elektrischen Kontaktierung einer Abschirmung (16) eines elektrischen Kabels (2) an einem Gehäuse (4), mit einem elektrischen Kabel (2), das eine von einem Kabelmantel (30) umgebene Abschirmung (16) aufweist und das im montierten Zustand durch einen Kabelstutzen (14) des Gehäuses (4) hindurch in das Gehäuse (4) geführt ist und dort an einem Kontaktelement (8) endet, mit einer Unterziehhülse (20), sowie mit einer Kontakthülse (18), wobei die Kontakthülse (18) gegen die Unterziehhülse (20) unter Zwischenlage der Abschirmung (16) verpresst ist, **dadurch gekennzeichnet, dass** die Kontakthülse (18) stirnendseitig mehrere als Federzungen (32) ausgebildete Kontaktfedern aufweist, die im montierten Zustand gegen eine Innenwandung des Kabelstutzens (14) anliegen, und dass im montierten Zustand eine Verschlusskappe (10) über den Kabelstutzen (14) gestülpt und mit diesem verbunden ist, in der die Kontakthülse (18) einliegt.

2. Vorrichtung nach Anspruch 1, bei der die Verschlusskappe (10) im montierten Zustand über eine Schnappverbindung (12) mit dem Kabelstutzen (14) verbunden ist.

3. Vorrichtung nach Anspruch 1 oder 2, bei der die Verschlusskappe (10) Teil einer zweiteiligen Kappenanordnung ist, die neben der Verschlusskappe (10) eine Schutzkappe (60) aufweist, welche als temporärer Transportschutz dient und sich an die Verschlusskappe (10) anschließt und einen frontseitigen Teil der Kontakthülse (18) einhaust.

4. Vorrichtung nach einem der vorhergehenden Ansprüche, bei der die Kontakthülse (18) beidendseitig Federzungen (32) aufweist.

5. Vorrichtung nach einem der vorhergehenden Ansprüche, bei der die Federzungen (32) unterschiedlich zueinander ausgebildet sind, so dass sie unterschiedliche Eigenfrequenzen aufweisen.

6. Vorrichtung nach einem der vorhergehenden Ansprüche, bei der die Kontakthülse (18) aus einem Blechbiegestanzteil gebildet ist und bei der die Kontaktfedern (32) einen Stanzgrad aufweisen, der in radialer Richtung nach außen gerichtet ist.

7. Vorrichtung nach einem der vorhergehenden Ansprüche, bei der ein hülsenförmiger Halter (22) angeordnet ist, wobei zwischen dem Halter (22) und einem Boden (38) der Verschlusskappe (10) ein Dichtelement (23) einliegt, durch welches das Kabel (2) durchgeführt ist, wobei der Halter (22) bevorzugt einen Hülsenschaft (34) aufweist, mit dem er am Kabelmantel (30) anliegt und wobei Kontaktfedern (32) der Kontakthülse (18) über den Hülsenschaft (34) gestülpt sind.

8. Vorrichtung nach einem der vorhergehenden Ansprüche, bei der ein Abstandshalter angeordnet ist, insbesondere der Halter (22) gemäß Anspruch 7, welcher einen Ringsteg (36) aufweist, der das Kabel (2) im Kabeleingang (6) zentriert hält.

9. Vorrichtung nach einem der vorhergehenden Ansprüche, bei der der Kabelstutzen (14) einen Anschlag (42) aufweist, an den sich die Kontakthülse (18) in Längsrichtung abstützt.

10. Vorrichtung nach einem der vorhergehenden Ansprüche, bei der die Kontakthülse (18) von einer Zwischenhülse (54) umgeben ist, welche im montierten Zustand zwischen der Kontakthülse (18) und dem Kabelstutzen (14) positioniert ist.

11. Vorrichtung nach Anspruch 10, bei der die Zwischenhülse (54) zur formschlüssigen axialen Fixierung der Kontakthülse (18) innerhalb des Kabelstutzens (14) ausgebildet ist und hierzu zwischen einem Anschlag (42) des Kabelstutzens (14) und einem Kragen (50) wahlweise der Unterziehhülse (20) oder der Kontakthülse (18) einliegt.

12. Vorrichtung nach einem der vorhergehenden Ansprüche, bei der um die Kontakthülse (18) eine Hilfshülse (52) angeordnet ist.

13. Vorrichtung nach einem der vorhergehenden Ansprüche, bei dem im Kabelstutzen (14) ein Einsatz (58) aus einem zum Kabelstutzen (14) verschiedenen Material eingesetzt ist und an dem Einsatz (58) die Federzungen (32) im montierten Zustand anliegen.

14. Vorkonfektioniertes elektrisches Kabel (2A) für eine Vorrichtung nach einem der vorhergehenden Ansprüche und zum Durchführen durch einen Kabelstutzen (14) eines Gehäuses (4), wobei das Kabel (2A) eine von einem Kabelmantel (30) umgebene Abschirmung (16) aufweist, mit einer Unterziehhülse (20) und mit einer Kontakthülse (18), die gegen die Unterziehhülse (20) unter Zwischenlage der Abschirmung (16) verpresst ist, **dadurch gekennzeichnet, dass** die Kontakthülse (18) stirnendseitig mehrere als Federzungen (32) ausgebildete Kontaktfedern aufweist, die für eine Kontaktierung mit einer Innenwandung des Kabelstutzens (14) ausgebildet sind und dass über den Kabelmantel (30) eine Verschlusskappe (10) gestülpt ist, welche die Kontakthülse (18) umgibt und die für ein Überstülpen des Kabelstutzens (14) und zur Verbindung mit diesem ausgebildet ist und an einer definierten Position am Kabelmantel fixiert ist, wobei zwischen der Kontakthülse und der Verschlusskappe (10) ein Ringraum ausgebildet ist.

15. Vorkonfektioniertes elektrisches Kabel (2A) nach Anspruch 14, bei der die Verschlusskappe (10) Teil einer zweiteiligen Kappenanordnung ist, die neben der Verschlusskappe (10) eine Schutzkappe (60) aufweist, welche als temporärer Transportschutz dient und sich an die Verschlusskappe (10) anschließt und einen frontseitigen Teil der Kontakthülse (18) einhaust.

## Claims

1. Device for establishing electrical contact between a shield (16) of an electrical cable (2) and a housing (4), having an electrical cable (2) which has a shield (16) which is surrounded by a cable sheathing (30) and which in the fitted state by way of a cable gland (14) of the housing (4) is routed through the housing (4) and terminates there at a contact element (B), having an under-sleeve (20), and having a contact sleeve (18), wherein the contact sleeve (18) is press-fitted to the under-sleeve (20) while the shield (16) is interlayered, **characterized in that** the contact sleeve (18) at the end side has a plurality of contact tongues which are configured as springs tongue (32) and which in the fitted state bear on an internal wall of the cable gland (14), and **in that** in the fitted state a closure cap (10) is pulled over the cable gland (14) in which the contact sleeve (18) is embedded, and is connected thereto.

2. Device according to Claim 1, wherein the closure cap (10) in the fitted state is connected to the cable gland (14) by way of a snap-fit connection (12) .

3. Device according to Claim 1 or 2, wherein the closure cap (10) is part of a bipartite cap assembly which apart from the closure cap (10) has a protective cap (60) which serves as temporary transportation protection device and adjoins the closure cap (10) and houses a front-side part of the contact sleeve (18).

4. Device according to one of the preceding claims, wherein the contact sleeve (18) at both end sides has spring tongues (32).

5. Device according to one of the preceding claims, wherein the spring tongues (32) are configured so as to be dissimilar to one another, so as to have dissimilar natural frequencies.

6. Device according to one of the preceding claims, wherein the contact sleeve (18) is formed from a bent punched sheet-metal part and wherein the contact springs (32) have a punching degree which in the radial direction is outwardly oriented.

7. Device according to one of the preceding claims, wherein a sleeve-shaped holder (22) is disposed, wherein a sealing element (23) is embedded between the holder (22) and a base (38) of the closure cap (10), the cable (2) being routed through said sealing element (23), wherein the holder (22) preferably has a sleeve shaft (34) by way of which said holder bears on the cable sheathing (30) and wherein contact springs (32) of the contact sleeve (18) are pulled over the sleeve shaft (34).

8. Device according to one of the preceding claims, wherein a spacer, in particular the holder (22) according to Claim 7, which has an annular web (36) which holds the cable (2) in a centric manner in the cable entry (6) is disposed.

9. Device according to one of the preceding claims, wherein the cable gland (14) has a stop (42) on which the contact sleeve (18) is supported in the longitudinal direction.

10. Device according to one of the preceding claims, wherein the contact sleeve (18) is surrounded by an intermediate sleeve (54) which in the fitted state is positioned between the contact sleeve (18) and the cable gland (14).

11. Device according to Claim 10, wherein the intermediate sleeve (54) for axially fixing the contact sleeve (18) in a form-fitting manner is configured within the cable gland (14) and to this end is embedded between a stop (42) of the cable gland (14) and a collar (50) of optionally the under-sleeve (20) or the contact sleeve (18).

12. Device according to one of the preceding claims, wherein an auxiliary sleeve (52) is disposed around the contact sleeve (18).

13. Device according to one of the preceding claims, wherein an insert (58) from a material which is dissimilar to that of the cable gland (14) is inserted in the cable gland (14), the spring tongues (32) in the fitted state bearing on said insert (58).

14. Pre-assembled electrical cable (2A) for a device according to one of the preceding claims and for routing through a cable gland (14) of a housing (4), wherein the cable (2A) has a shield (16) which is surrounded by a cable sheathing (30), having an under-sleeve (20), and having a contact sleeve (18) which is press-fitted to the under-sleeve (20) while the shield (16) is interlayered, **characterized in that** the contact sleeve (18) at the end side has a plurality of contact springs which are configured as springs tongue (32) and which are configured for establishing electrical contact on an internal wall of the cable gland (14), and **in that** a closure cap (10) which surrounds the contact sleeve (18) and which is configured for being pulled over the cable gland (14) and for connection thereto is pulled over the cable sheathing (30) and is fixed in a defined position to the cable sheathing, wherein an annular space is configured between the contact sleeve and the closure cap (10).

15. Pre-assembled electrical cable (2A) according to Claim 14, wherein the closure cap (10) is part of a bipartite cap assembly which apart from the closure cap (10) has a protective cap (60) which serves as a temporary transportation protection device and which adjoins the closure cap (10) and houses a front-side part of the contact sleeve (18) .

## Revendications

1. Dispositif de mise en contact électrique d'un blindage (16) d'un câble électrique (2) au niveau d'un boîtier (4), comprenant un câble électrique (2) qui possède un blindage (16) entouré par une gaine de câble (30) et qui, à l'état monté, est introduit dans le boîtier (4) à travers un manchon passe-câble (14) du boîtier (4) et s'y termine au niveau d'un élément de contact (8), comprenant une douille de renfort (20) et comprenant aussi une douille de contact (18), la douille de contact (18) étant pressée contre la douille de renfort (20) en interposant le blindage (16), **caractérisé en ce que** la douille de contact (18) possède du côté de l'extrémité frontale plusieurs ressorts de contact réalisés sous la forme de languettes flexibles (32) qui, à l'état monté, reposent contre une paroi intérieure du manchon passe-câble (14), et **en ce qu'**à l'état monté, un capuchon de fermeture (10) dans lequel repose la douille de contact (18) est rabattu sur le manchon passe-câble (14) et relié avec celui-ci.

2. Dispositif selon la revendication 1, dans lequel le capuchon de fermeture (10), à l'état fermé, est relié au manchon passe-câble (14) par le biais d'un assemblage par encliquetage (12).

3. Dispositif selon la revendication 1 ou 2, dans lequel le capuchon de fermeture (10) fait partie d'un arrangement de capuchon en deux parties qui, outre le capuchon de fermeture (10), possède un capuchon de protection (60) qui sert de protection au transport temporaire et qui se rattache au capuchon de fermeture (10) et accueille une partie côté avant de la douille de contact (18).

4. Dispositif selon l'une des revendications précédentes, dans lequel la douille de contact (18) possède des languettes flexibles (32) du côté des deux extrémités.

5. Dispositif selon l'une des revendications précédentes, dans lequel les languettes flexibles (32) sont de configurations différentes les unes des autres, de sorte qu'elles possèdent des fréquences de résonance différentes.

6. Dispositif selon l'une des revendications précédentes, dans lequel la douille de contact (18) est constituée d'une pièce pliée et découpée en tôle et dans lequel les ressorts de contact (32) possèdent un degré de découpe qui est orienté vers l'extérieur dans le sens radial.

7. Dispositif selon l'une des revendications précédentes, dans lequel un support (22) en forme de douille est monté, un élément d'étanchéité (23) à travers lequel passe le câble (2) étant introduit entre le support (22) et un fond (38) du capuchon de fermeture (10), le support (22) possédant de préférence un fût de douille (34) dans lequel il repose contre la gaine de câble (30) et les ressorts de contact (32) de la douille de contact (18) étant rabattus sur le fût de douille (34).

8. Dispositif selon l'une des revendications précédentes, dans lequel une entretoise est montée, notamment le support (22) selon la revendication 7, laquelle possède un élément jointif annulaire (36) qui maintient le câble (2) centré dans l'entrée de câble (6) .

9. Dispositif selon l'une des revendications précédentes, dans lequel le manchon passe-câble (14) possède une butée (42) contre laquelle la douille de contact (18) s'appuie dans le sens longitudinal.

10. Dispositif selon l'une des revendications précédentes, dans lequel la douille de contact (18) est entourée par une douille intermédiaire (54) qui, à l'état monté, est positionnée entre la douille de contact (18) et le manchon passe-câble (14).

11. Dispositif selon la revendication 10, dans lequel la douille intermédiaire (54) est configurée pour une fixation axiale par complémentarité de formes de la douille de contact (18) à l'intérieur du manchon passe-câble (14) et est introduite à cet effet entre une butée (42) du manchon passe-câble (14) et une collerette (50), au choix de la douille de renfort (20) ou de la douille de contact (18).

12. Dispositif selon l'une des revendications précédentes, dans lequel une douille auxiliaire (52) est disposée autour de la douille de contact (18).

13. Dispositif selon l'une des revendications précédentes, dans lequel un insert (58) en un matériau différent de celui du manchon passe-câble (14) est inséré dans le manchon passe-câble (14) et les languettes flexibles (32) reposant sur l'insert (58) à l'état monté.

14. Câble électrique (2A) préconfectionné pour un dispositif selon l'une des revendications précédentes et destiné à être passé à travers un manchon passe-câble (14) d'un boîtier (4), le câble (2A) possédant un blindage (16) entouré par une gaine de câble (30), comprenant une douille de renfort (20) et comprenant une douille de contact (18) qui est pressée contre la douille de renfort (20) en interposant le blindage (16), **caractérisé en ce que** la douille de contact (18) possède du côté de l'extrémité frontale plusieurs ressorts de contact réalisés sous la forme de languettes flexibles (32) qui sont configurés pour une mise en contact avec une paroi intérieure du manchon passe-câble (14), et **en ce qu'**un capuchon de fermeture (10) est rabattu au-dessus de la gaine de câble (30), lequel entoure la douille de contact (18) et est configuré pour recouvrir le manchon passe-câble (14) en étant rabattu sur celui-ci et pour être relié à celui-ci, et lequel est fixé au niveau d'une position définie sur la gaine de câble, un espace annulaire étant formé entre la douille de contact et le capuchon de fermeture (10) .

15. Câble électrique (2A) préconfectionné selon la revendication 14, dans lequel le capuchon de fermeture (10) fait partie d'un arrangement de capuchon en deux parties qui, outre le capuchon de fermeture (10), possède un capuchon de protection (60) qui sert de protection au transport temporaire et qui se rattache au capuchon de fermeture (10) et accueille une partie côté avant de la douille de contact (18).
